# EUROPEAN PATENT APPLICATION

(11) **EP 4 462 961 A1**
(43) Date of publication of application: **13.11.2024**
(21) Application number: 23172865.0
(22) Date of filing: 11.05.2023
(51) Int. Cl.: H05K 3/32, H01R 12/58, G01R 1/20, H05K 1/11

(54) **JOINT, ELECTRICAL ASSEMBLY, ELECTRICAL MEASUREMENT DEVICE AND MANUFACTURING METHOD**

(71) Applicant: TE Connectivity Solutions GmbH, 8200 Schaffhausen (CH)
(72) Inventor: SCHERNER, Simon, 8200 Schaffhausen (CH); ZAWADZKY, Peter, 8200 Schaffhausen (CH); GLASER, Karlheinz, 8200 Schaffhausen (CH); EBERLE, Marcus, 8200 Schaffhausen (CH); KARABIYIK, Hamdi, 8200 Schaffhausen (CH)
(74) Representative: Grünecker Patent- und Rechtsanwälte PartG mbB

(57) **Abstract**

The present invention relates to a preferably rigid joint (3) for attaching a printed circuit board (20) to a solid electrical conductor (22), wherein the joint (3) comprises an electrically conductive lining (34), which lines an inner surface of a through-hole (26) in the printed circuit board (20), and a tenon (62) pressed in into the through-hole (26) being in frictional as well as in electrical contact with the electrically conductive lining (34), wherein the tenon (62) is monolithically formed from the material of the solid electrical conductor (22). In the joint (3), the lining (34) of the through-hole (26) functions as a mortise for the tenon (62), while it also functions to establish an electrical connection. Further, the present invention relates to an electrical assembly (2) with such a joint (3), an electrical measurement device (1) with such an electrical assembly (2) and a method for the manufacturing of such an electrical assembly (2).

## Description

### Technical Field to Which the Invention Relates and Background Art

The present invention relates to a joint, preferably a rigid joint for attaching or mounting a printed circuit board (PCB) to a solid electrical conductor, such as a busbar, a shunt or any other type of conductor massively made of an electrically conductive material. Further, the present invention relates to an electrical assembly for an electrical device, such as an electrical measurement device, control system unit or the like comprising such a joint. Moreover, the present invention relates to a solid electrical conductor for such an electrical assembly, an electrical measurement device comprising such an electrical assembly and a method for manufacturing such an electrical assembly.

For many applications in the field of electrical engineering, printed circuit boards of electrical devices need to be attached to solid electrical conductors. Conventionally, this kind of attachment is established by arranging a separate connection element between the printed circuit board and the solid electrical conductor.

Not only is said connection element an additional part that requires handling, but it also usually produces scrap during its manufacturing. Moreover, said connection element has to be welded, soldered, glued, screwed or otherwise mechanically fixated to the solid electrical conductor. This imposes certain restrictions on the choice of material with regard to aspects such as weldability and solderability. The necessary mechanical fixation of the connection element also results in additional interconnections that might fail after a certain time. The risk of such a failure increases, for example, if a high vibration load is to be expected.

Therefore, it is desirable to improve the attachment of printed circuit boards to solid electrical conductors by overcoming the above-mentioned issues.

### Object to be Achieved

The object of the present invention is to provide means for improving, in general, the attachment of printed circuit boards to solid electrical conductors, and, in particular, for improving the joint between the printed circuit board and the solid electrical conductor.

### Disclosure of Invention

The object is achieved with a joint of the above-mentioned type, wherein the joint comprises an electrically conductive lining, which lines an inner surface of a through-hole in the printed circuit board, and a tenon, which is pressed in into the through-hole and is in frictional as well as in electrical contact with the electrically conductive lining, wherein the tenon is monolithically formed from the material of the solid electrical conductor.

The technical effects and advantages achieved by the above solution are as follows:
The electrically conductive lining in the through-hole functions as a mortise, with which the tenon frictionally engages, effecting a mechanical connection between the printed circuit board and the solid electrical conductor (henceforth: the mechanical connection). At the same time, the electrically conductive lining and the tenon provide contact surfaces, which are in mutual electrical contact, establishing an electrical connection between the printed circuit board and the solid electrical conductor (henceforth: the electrical connection).

The tenon is monolithically formed from the material of the solid electrical conductor, which eliminates the necessity for any separate fixation element. The absence of separate fixation elements results in less scrap being produced and less parts being required for the attachment of the printed circuit board to the solid electrical conductor. Less parts also means that less boundary areas between the parts are present in the joint, leading to a lower electrical transfer resistance. Hence, any electrical assembly utilizing the joint will not only be improved from an economic viewpoint, but will also exhibit better performance during its operation compared to a conventional electrical assembly with a separate connection element.

If the joint is utilized in an electrical assembly for measurement applications, specifically electrical measurement applications, the at least one tenon being monolithically, and thus integrally formed from the material of the solid electrical conductor results in another advantage. Namely, fewer interconnections along the measurement path are present, therefore reducing the Failures In Time (FIT) Rate effectively. Further, the EMC behavior is improved due to the shortened measurement path, which results from having fewer interconnections.

The initial objective is also achieved with an electrical assembly for an electrical measurement device, the electrical assembly comprising at least one joint according to the present invention, a solid electrical conductor with the tenon of the at least one joint, and a printed circuit board with at least one through-hole lined with the electrically conductive lining of the at least one joint, wherein the tenon at least sectionally extends into the at least one through-hole.

The electrical assembly benefits from the above-explained technical effects and advantages of the joint, when it is used in an electrical device, such as an electrical measurement device, control system unit or the like. In particular, the manufacturability, profitability and performance of the electrical assembly are improved by means of the joint according to the present invention.

Further, the initial objective is achieved by an electrical measurement device comprising the above electrical assembly and an electrical sensor, wherein the electrical sensor is connected to the electrically conductive lining of the at least one joint.

Like the electrical assembly, the electrical measurement device also benefits from the above-explained technical effects and advantages of the joint. In particular, the electrical sensor connected to the electrically conductive lining can be used to measure the electrical values of the solid electrical conductor of which at least one tenon is in electrical contact with the lining.

Moreover, the initial objective is achieved by a method for the manufacturing of an electrical assembly comprising the steps of providing a substantially flat, solid electrical conductor and a printed circuit board with at least one through-hole, lining the at least one through-hole with an electrically conductive material, coining the solid electrical conductor to monolithically form, from the material of the solid electrical conductor, at least one tenon, pressing in the at least one tenon into the at least one through-hole to establish a frictional as well as an electrical connection between the at least one tenon and the electrically conductive material.

Compared to other manufacturing methods of comparable electrical assemblies, the inventive method produces less scrap and involves less parts, since the at least one tenon is formed by coining in a chipless manner. Further, the resulting electrical assembly comprises at least one joint exhibiting the advantages and functions explained above.

The above solution may be further improved by adding one or more of the following optional features. Each of the following optional features is advantageous on its own and may be combined independently with any of the other optional features.

According to a first possible embodiment of the electrical assembly, the solid electrical conductor may be substantially flat or have at least one flat side. On said flat side of the solid electrical conductor, the tenon may be monolithically formed from the material of the solid electrical conductor. Said flat side may be facing towards a bottom side of the printed circuit board and may be referred to as a top side of the solid electrical conductor. In other words, the tenon may be located on the top side of the solid electrical conductor.

Advantageously, conventionally available solid conductors may serve as raw material. For example, the solid electrical conductor may be made of copper, copper alloy, in particular copper wrought alloy, aluminum, aluminum alloy, stainless steel and any other metallic or metallized material with a ductility suitable for coining, stamping, pressing, punching, embossing and/or similar processes that can be used for monolithically forming the tenon from the material of the solid electrical conductor.

Optionally, the solid electrical conductor may comprise a coating, in particular a plasma coating; a plating, in particular a chemical plating or electro-plating; a brazing; a cladding or any other type of metal application to its surface. The applied metal may be a rare and/or precious and/or typical conductive metal (e.g., silver) or a rare and/or precious and/or typical conductive metal alloy for reduced contact resistance. The metal may be applied entirely or only partly on the solid electrical conductor. For example, a Sn metallization via plasma may be applied to the outer surface of the at least one tenon, while the remaining surface of the solid electrical conductor may be left untreated.

According to another possible embodiment of the electrical assembly, the solid electrical conductor may comprise at least one indent or indentation on a bottom side of the solid electrical conductor facing away from the printed circuit board. Preferably, the at least one indent is located opposite of the at least one tenon with respect to the solid electrical conductor. The at least one indent creates a blind hole in the solid electrical conductor. This is a result of material displacement during the monolithic formation of the at least one tenon from the material of the solid electrical conductor.

Each tenon may be a pillar-shaped, pin-shaped, prism-shaped, pole-shaped and/or post-shaped finger or protrusion. As will be described below, the cross section of each tenon may have a circular, square, rectangular, triangular, polygonal, oval, elliptical or other non-circular shape. Accordingly, the at least one through-hole may have a circular or non-circular cross section, in particular for an inner contour.

Further, each tenon may protrude from the top side of the solid electrical conductor along an axial direction, in order to extend into one corresponding through-hole of the printed circuit board. A tip of each tenon may be flush with a top side of the printed circuit board or may even project or stick out from the top side of the printed circuit board. Alternatively, the tip of each tenon may be located within the corresponding through-hole, without sticking out.

According to another possible embodiment of the joint, the mechanical connection of the tenon and through-hole, in particular its lining, may be obtained by a so-called massive press fit. For this purpose, the tenon may have a slightly over-sized non-circular cross section and the through-hole, in particular its lining, may have a slightly under-sized circular cross section. It is also conceivable that the through-hole, in particular its lining, has a non-circular cross section, while the tenon has a circular cross section. In particular, the non-circular cross section of the tenon or lining may have the shape of a square, rectangle, triangle, polygon, oval, ellipse, clover, cross or any other non-circular regular or irregular geometric form. Optionally, a suitable sleeve made of electrically conductive material may be positioned inside of the through-hole. The sleeve may have inwardly extending spikes, ribs, knobs or other convex protrusions to arrive at the non-circular cross section of the lining.

With this deliberate mismatching of shapes and sizes of the cross sections in place, the tenon is forced into the through-hole resulting in the massive press fit. In the course of the massive press fit, the electrically conductive lining of the through-hole may be at least in sections cold-welded with the tenon. This advantageously renders the electrical contact within the joint gastight. In particular, no oxide layer can be formed between the lining and the tenon in the cold-welded sections.

If it is expected that an oxide layer is already present on the lining and/or tenon before the joint is created, the tenon may comprise at least one edge that incises into the electrically conductive lining of the through-hole. The at least one edge may be a cutting edge and/or may extend along an axial direction with respect to the tenon. With the at least one edge, the oxide layer can be scraped away when the joint is created.

In any given cross section of the tenon that is perpendicular to the axial direction of the tenon, it is sufficient if the tenon only engages the lining frictionally and electrically in sections. Elsewhere in that cross section, the lining and the tenon may be sectionally spaced apart and/or distanced from each other. This concentrates and increases the acting normal force at the locations of engagement between the tenon and lining.

For example, the tenon may be arranged eccentrically with respect to the through-hole and may only one-sidedly engage with the lining of the through-hole. This way, the tenon does not have to fill up the entire cross section of the through-hole and less material is required. In particular, a distance by which a middle axis of the tenon is shifted from a middle axis of the through-hole may be equal to or larger than the difference between the inner radius of the through-hole and the outer radius of the tenon.

In this case, the circularity of the cross section of the tenon and the through-hole is irrelevant. However, it has to be ensured that the tenon cannot "shift back" relative to the through-hole. For example, multiple pairs of tenons and through-holes need to be provided, wherein the middle axes of the tenons are shifted in mutually opposite directions from the middle axes of the through-holes. Alternatively, if only one tenon and one through-hole are present, it may be guaranteed that the printed circuit board and the solid electrical conductor are fixated in their relative position by use of a housing, in which the electrical assembly is accommodated.

The printed circuit board may comprise a substrate made of glass-reinforced epoxy laminate material, in particular of the category FR-4 according to NEMA LI 1-1998 standard. With this choice of substrate material, the printed circuit board can withstand the forces acting at the at least one through-hole and at the electrically conductive lining.

Optionally, the electrically conductive lining may be formed by applying a coating to the inner surface of the through-hole or by placing an insert sleeve into the through-hole. If a tenon has the circular cross section, an inner cross section of the insert sleeve may have the shape of a square, rectangle, triangle, polygon, oval, ellipse, clover, cross or any other non-circular regular or irregular geometric form. For a tenon with the non-circular cross section, the inner cross section of the insert sleeve may be circular.

If the contact surface between the printed circuit board and the solid electrical connector needs to be increased, at least one elevation extending around the at least one tenon may be monolithically formed from the material of the solid electrical conductor. Further, the printed circuit board may comprise at least one electrically conductive trace extending at least sectionally around the at least one through-hole. The at least one elevation may be brought into electrical contact with the at least one electrically conductive trace.

Preferably, the at least one elevation may extend continuously around the at least one tenon. For example, the at least one elevation may be a ring-shaped bulge on the top side of the solid electrical conductor encircling the at least one tenon. Accordingly, the at least one electrically conductive trace may extend continuously around the at least one through-hole, in particular around an opening of the at least one through-hole on the above-mentioned bottom side of the printed circuit board. Herein, the electrically conductive lining and the at least one conductive trace may be electrically interconnected.

Alternatively, and in order to increase the contact pressure, the at least one elevation may extend discontinuously around the at least one tenon. For example, multiple convex knobs with a dome shape, spike shape, pyramid shape, cylinder shape, star shape or any other convexly protruding shape may be distributed around the at least one tenon, each knob defining a discrete contact point for the at least one electrically conductive trace. The knobs are preferably distributed in a circular arrangement and evenly or unevenly spaced apart from each other in a circumferential direction with respect to the at least one tenon. Moreover, the contact points may be mutually coplanar. This improves the positional stability of the printed circuit board. Accordingly, the at least one electrically conductive trace may extend discontinuously around the at least one through-hole, in particular around an opening of the at least one through-hole on the above-mentioned bottom side of the printed circuit board.

According to a further possible embodiment, at least one slit or notch may extend through the at least one elevation along a radial direction with respect to the at least one tenon. Preferably, multiple slits may be distributed in regular or irregular distances around the at least one elevation along a circumferential direction with respect to the at least one tenon. The slits may separate the at least one elevation into multiple ring segments, resulting in the discontinuously extending elevation.

Optionally, a groove is formed on the solid electrical conductor between the at least one tenon and the at least one elevation. Said groove may be circular and/or annular and may extend around the at least one tenon in the circumferential direction with respect to the at least one tenon. In a radial direction with respect to the at least one tenon, the groove may separate the at least one tenon and the at least one elevation from each other. Thereby, the groove serves as a relief groove or undercut allowing the printed circuit board to be fully seated against the shoulder formed by the at least one elevation.

According to another embodiment, two or more tenons may be formed on the solid electrical conductor, wherein each tenon is surrounded by an elevation formed on the solid electrical conductor. Accordingly, the printed circuit board may comprise two or more through-holes surrounded by electrically conductive traces at locations corresponding with the respective locations of the tenons and elevations. Preferably, the two or more tenons are mutually parallel. The two or more through-holes likewise may extend parallel to each other. The elevations may be mutually coplanar, just like the electrically conductive traces are mutually coplanar. This allows the printed circuit board to be attached to the solid electrical conductor at multiple locations. Not only is the mechanical stability of each joint increased this way, but also electrical connections are obtained at multiple locations, which can be utilized for certain electrical measurement applications, as will be described in further detail below.

According to another possible embodiment of the electrical assembly, the solid electrical conductor may be a shunt resistor with at least one resistive element and at least one connection terminal adjacent to the at least one resistive element. Preferably, the shunt resistor comprises two connection terminals with the resistive element located in between. The at least one tenon may be monolithically formed from the material of the resistive element or of the connection terminals. As such, the electrical assembly of this embodiment can be utilized in an active shunt for the measurement of electrical currents. This will be described below:

The shunt resistor can be arranged in a circuit in parallel with a voltmeter. For this, the at least one connection terminal may be configured as a terminal plate. Further, the at least one connection terminal may comprise at least one screw hole to connect the shunt resistor to the circuit of which the current values are to be measured.

To achieve the parallel arrangement, the shunt resistor comprises a pair of tenons, wherein the voltmeter is connected with the printed circuit board to all tenons. Preferably, one tenon is positioned on each of the opposite sides of the resistive element, such that the resistive element is parallel with the voltmeter.

The shunt resistor usually has a relatively low resistance, so that essentially all current to be measured flows through the shunt resistor. The above-mentioned embossing of the at least one tenon moves the material from the core of the solid conductor into the volume of the tenon. The resulting indent can reach a depth of up to 80% of the material thickness of the solid conductor and form the above-mentioned blind hole Consequently, the effect of a so-called current shadow is possible. In particular, the at least one indent creates a choke point that forces the electric current to flow as close as possible to the tenon on the opposite side of the shunt resistor.

The voltage across the shunt resistor is proportional to the current flowing through it and thus, the measured voltage can be scaled to directly display the current value. Therefore, the concrete resistance of the shunt resistor is chosen so that the resultant voltage drop is high enough to be measurable with the voltmeter, but low enough not to disrupt the circuit.

For accurate scaling, the actual resistance value of the shunt resistor has to be known as precisely as possible, since it influences the proportionality factor between the measured voltage and the current value. For this purpose, the resistance value of the resistive element needs to have a minimal temperature coefficient. That is, the resistance value of the resistive element should be virtually independent of the (operating) temperature. This is important, since electrical circuits, especially resistors, tend to heat up under load.

For this reason, the resistive element may be comprised of or consist of resistance alloys, which are conventionally known under names such as Manganin, Constantan, Isaohm or any other conductive material with a low thermal variation of its resistivity.

Nonetheless, the shunt resistor as a whole (including all of its remaining components, such as the connection terminals) exhibits a certain temperature dependency on its overall resistance value. Therefore, temperature will inevitably have an undesired impact on the measurement results of the current value. To overcome this issue, a means for temperature compensation can be applied.

For example, the electrical assembly may comprise a temperature sensor arranged on the above-mentioned bottom side of the printed circuit board facing the solid electrical conductor. The temperature sensor may be in thermal contact with the solid electrical conductor, directly and/or via a thermal paste. The measured temperatures of the temperature sensor may then be read by the electrical measurement device for the purpose of temperature compensation and monitoring.

Since, according to the present invention, no separate connection element is arranged between the printed circuit board and the solid electrical conductor, the printed circuit board and the solid electrical conductor are relatively close to each other. This allows for the use of surface mount devices (SMD) for the temperature sensor. In particular, one or more negative temperature coefficient (NTC) thermistors may be surface-mounted to the bottom side of the printed circuit board facing the solid electrical connector to form the temperature sensor.

According to another possible embodiment, the electrical assembly may comprise at least two pairs of joints, thus establishing a certain redundancy for electrical measurement applications. In particular, the joints of one pair may have the same distance to each other as the joints of the other pair. The joints of each pair may be aligned along an axial direction of the solid electrical conductor.

According to a possible embodiment of the electrical measurement device, the electrical measurement device may comprise at least one screw. As already described above, the shunt resistor may comprise at least one screw hole for passing the at least one screw. Further, the electrical measurement device may comprise a housing in which the electrical assembly and electrical sensor are accommodated.

Optionally, the electrically conductive lining may be connected with e.g., a sensor probe, a sensor wire and/or an internal printed circuit board of the electrical sensor. An exemplary electrical sensor may be the above-mentioned voltmeter or any other type of voltage measurement device. As such, the electrical measurement device may, for example, be used as an active shunt according to the principles explained above.

According to one possible embodiment of the manufacturing method, the method step of coining may involve stamping, pressing, punching and/or embossing the solid electrical conductor, wherein the at least one tenon is obtained or formed by plastically deforming the material of the solid electrical conductor. Thereby, no scrap is generated, at least during the method step of coining.

Moreover, a staged tool and/or a progressive tool may be used for the method step of coining in order to achieve a high shape accuracy when forming the at least one tenon. Optionally, the at least one tenon may have slightly slanted outer surfaces like a truncated cone or pyramid to facilitate exit from the coining tool. The slant angle may range from 0,1° to 1°.

Accordingly, the initial objective is also achieved by a solid electrical conductor comprising at least one tenon, wherein, the at least one tenon is obtained by plastically deforming the material of the solid electrical conductor. In particular, the solid electrical conductor and its at least one tenon may be configured according to the above-explained embodiments. Advantageously, any printed circuit board with a suitable via can be readily attached to the solid electrical conductor.

In the following, exemplary embodiments of the invention are described with reference to the drawings. The embodiments described and shown in the drawings are for explanatory purposes only. The combination of features shown in the embodiments may be changed according to the foregoing description. For example, a feature which is not shown in an embodiment, but described above may be added if the technical effect associated with this feature is beneficial for a particular application. Vice versa, a feature shown as part of an embodiment may be omitted as described above, if the technical effect associated with this feature is not needed in a particular application.

In the drawings, elements that correspond to each other with respect to function and/or structure have been provided with the same reference numeral.

In the drawings,
- Fig. 1: shows a schematic representation of an exploded view of an electrical measurement device according to a possible embodiment of the present disclosure;
- Fig. 2: shows a schematic representation of an exploded view of an electrical assembly according to a first possible embodiment of the present disclosure;
- Fig. 3: shows a schematic representation of a sectional view of the electrical assembly from Fig. 2;
- Fig. 4: shows a schematic representation of a top view of the electrical assembly from Fig. 2;
- Fig. 5: shows a schematic representation of a top view of an electrical assembly according to a second possible embodiment of the present disclosure;
- Fig. 6: shows a schematic representation of a top view of an electrical assembly according to a third possible embodiment of the present disclosure;
- Fig. 7: shows a schematic representation of a top view of an electrical assembly according to a fourth possible embodiment of the present disclosure;
- Fig. 8: shows a schematic representation of a top view of an electrical assembly according to a fifth possible embodiment of the present disclosure;
- Fig. 9: shows a schematic representation of a top view of an electrical assembly according to a sixth possible embodiment of the present disclosure;
- Fig. 10: shows a schematic representation of a top view of an electrical assembly according to a seventh possible embodiment of the present disclosure;
- Fig. 11: shows a schematic representation of a perspective view of a solid electrical conductor according to a possible embodiment of the present disclosure;
- Fig. 12: shows a schematic representation of a detail XII of Fig. 11;
- Fig. 13: shows a schematic representation of a perspective view of a tenon and elevation according to a possible embodiment of the present disclosure;
- Fig. 14: shows a schematic representation of a perspective view of a tenon and elevation according to another possible embodiment of the present disclosure; and
- Fig. 15: shows a schematic representation of an exploded view of an electrical assembly according to an eighth possible embodiment of the present disclosure.

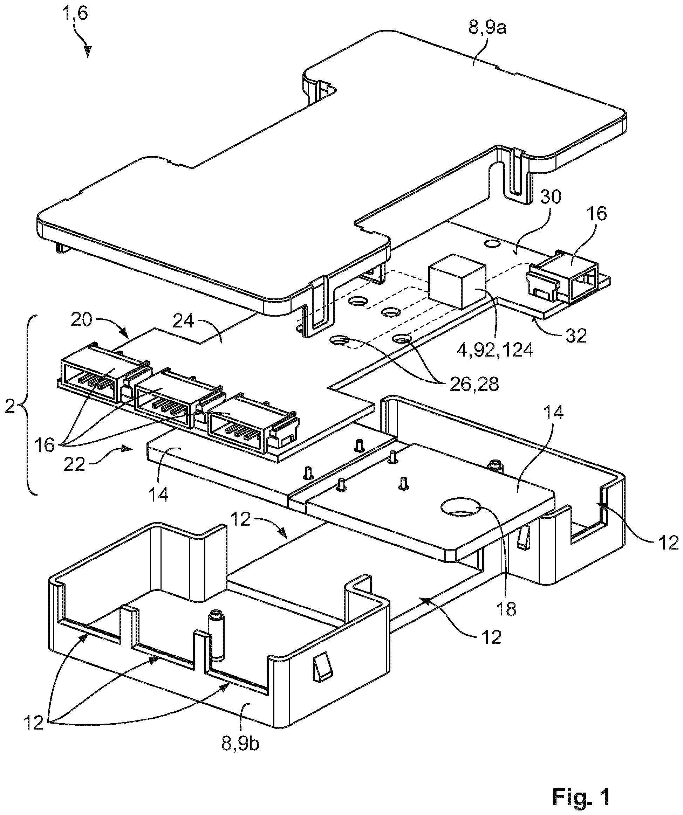

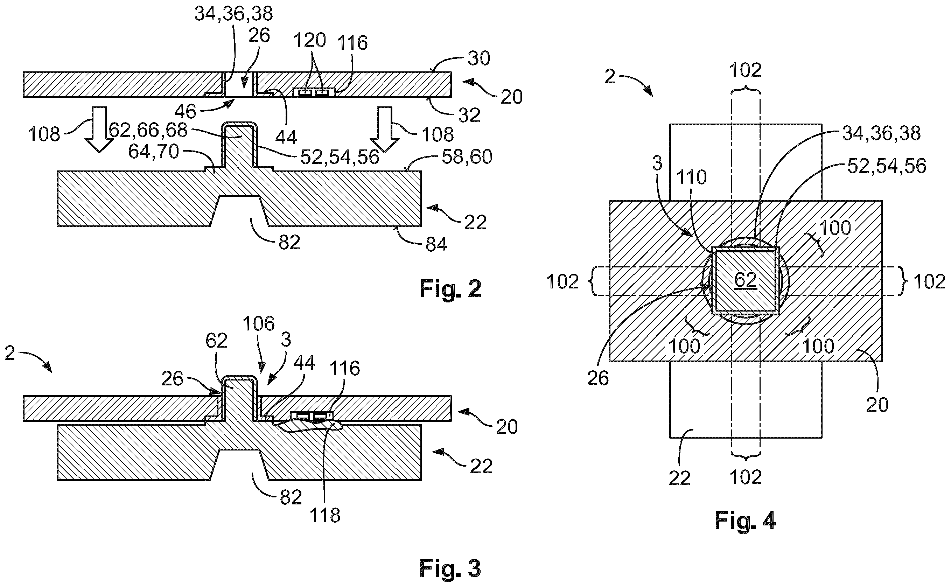

First, the structure of a possible embodiment of an electrical measurement device 1 according to the present invention is explained with reference to Fig. 1. Next, Figs. 2 to 15 are used to explain the structure of possible embodiments of an electrical assembly 2 and a joint 3, respectively. Lastly, a manufacturing method according to the present invention is explained with reference to Figs. 2 to 4.

Fig. 1 shows an exploded view of the electrical measurement device 1 according to one possible embodiment of the present disclosure. The electrical measurement device 1 comprises the electrical assembly 2 and an electrical sensor 4, which is connected to the electrical assembly 2. An example of an electrical sensor 4 may be or comprise of a voltmeter 92 or any type of signal conditioning device 124. In this specific embodiment, the electrical measurement device 1 may, for example, be used as an active shunt 6 for the measurement of electrical currents. This will be explained further below.

Moreover, the electrical measurement device 1 may comprise a housing 8 in which the electrical assembly 2 and the electrical sensor 4 are accommodated. In the shown embodiment of Fig. 1, a two-part housing 8 comprised of two housing halves 9a, 9b is provided. The housing halves 9a, 9b may be configured to be clipped together. Alternatively, the housing halves 9a, 9b may also be glued, welded, soldered or screwed together. Further, a partial or complete overmolding of the electrical measurement device 1 with a thermo- and/or duroplastic material is also possible.

Further, the housing 8 may have one or more access openings 12. Through these access openings 12, the electrical assembly 2 may be accessible from outside the housing 8. For example, the connection terminals 14 and/or card-edge connectors 16 of the electrical assembly 2 may extend through the access openings 12 or at least be aligned with the access openings 12 inside the housing 8. The connection terminals 14 may be plate-shaped and each comprise a screw hole 18 for passing a screw (not shown). The corresponding screw may be an optional part of the electrical measurement device 1.

In Fig. 2, an exploded sectional view of a possible embodiment of the electrical assembly 2 is shown. As can be seen, the electrical assembly 2 comprises a printed circuit board 20 and a solid electrical conductor 22. The printed circuit board 20 is attached to the solid electrical conductor 22 by means of the joint 3 (see Fig. 3).

The printed circuit board 20 may comprise a substrate 24 made of glass-reinforced epoxy laminate material, in particular of the category FR-4 according to NEMA LI 1-1998 standard. Through the substrate of the printed circuit board 20, at least one through-hole 26, in particular a via 28 (vertical interconnect access) may extend. As such, the at least one through-hole 26 may connect a top side 30 of the printed circuit board 20 with a bottom side 32 of the printed circuit board 20.

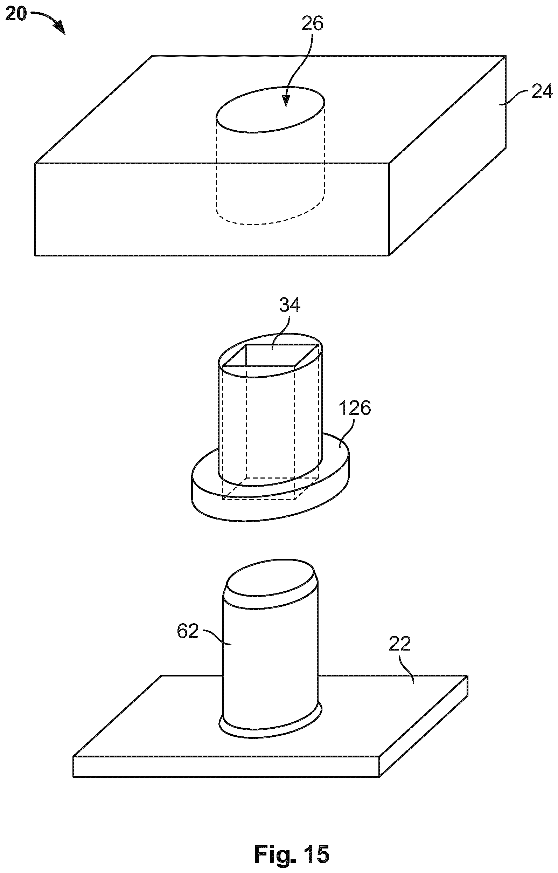

The at least one through-hole 26 may comprise an electrically conductive lining 34. In particular, the electrically conductive lining 34 may be achieved through a metallic plating 36, metallic coating 38 and/or metallic insert sleeve 126 (see Fig. 15) within the at least one through-hole 26.

On the bottom side 32, the printed circuit board 20 may comprise at least one electrically conductive trace 44 extending at least sectionally around the at least one through-hole 26, in particular around an opening 46 of the at least one through-hole 26. The at least one electrically conductive trace 44 may extend continuously or discontinuously around the at least one through-hole 26. Preferably, the electrically conductive lining 34 and the at least one conductive trace 44 are electrically interconnected.

The solid electrical conductor 22 may be a busbar 48, a shunt 50 or any other type of conductor massively made of electrically conductive material. For example, the solid electrical conductor 22 may be made of copper, copper alloy, in particular copper wrought alloy, aluminum, aluminum alloy, stainless steel or any other metallic or metallized material with a ductility suitable for coining, stamping, pressing, punching, embossing and/or similar processes. Optionally, the solid electrical conductor 22 may at least in sections comprise a coating 52, plating 54 or brazing 56 of a rare metal (e.g., silver) or a rare metal alloy.

Further, the solid electrical conductor 22 may be substantially flat or have at least one flat side 58. Said flat side 58 may be facing towards the bottom side 32 of the printed circuit board 20 and may be referred to as a top side 60 of the solid electrical conductor 22. On said top side 60, at least one tenon 62 may be monolithically formed from the material of the solid electrical conductor 22. Optionally, at least one elevation 64 extending around the at least one tenon 62 may also be monolithically formed from the material of the solid electrical conductor 22.

In particular, the at least one tenon 62 and the at least one elevation 64 may be formed by coining, stamping, pressing, punching or embossing and thereby plastically deforming the solid electrical conductor 22. Hence, the above-mentioned requirement for the material ductility for the solid electrical conductor 22 is set.

The joint 3 comprises the electrically conductive lining 34 and the tenon 62, which is pressed in into the through-hole 26 and is in frictional as well as in electrical contact with the electrically conductive lining 34.

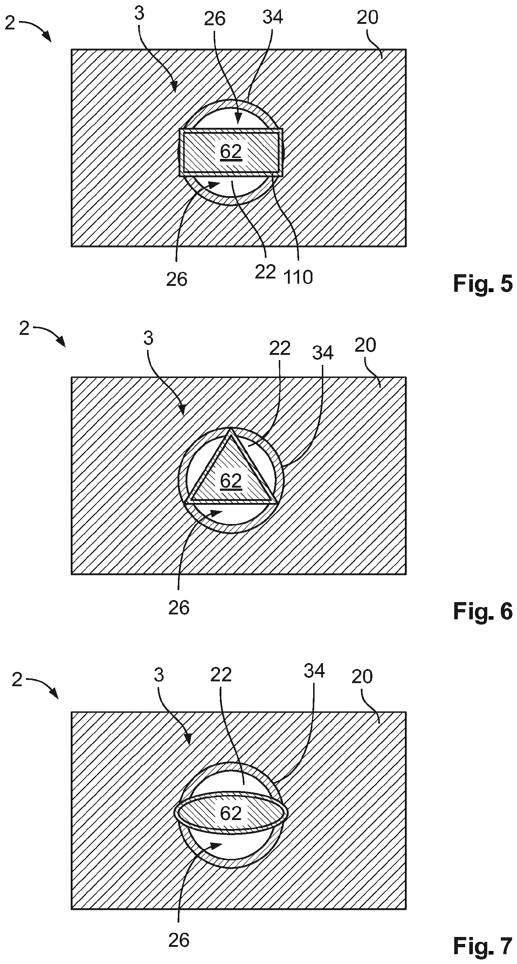

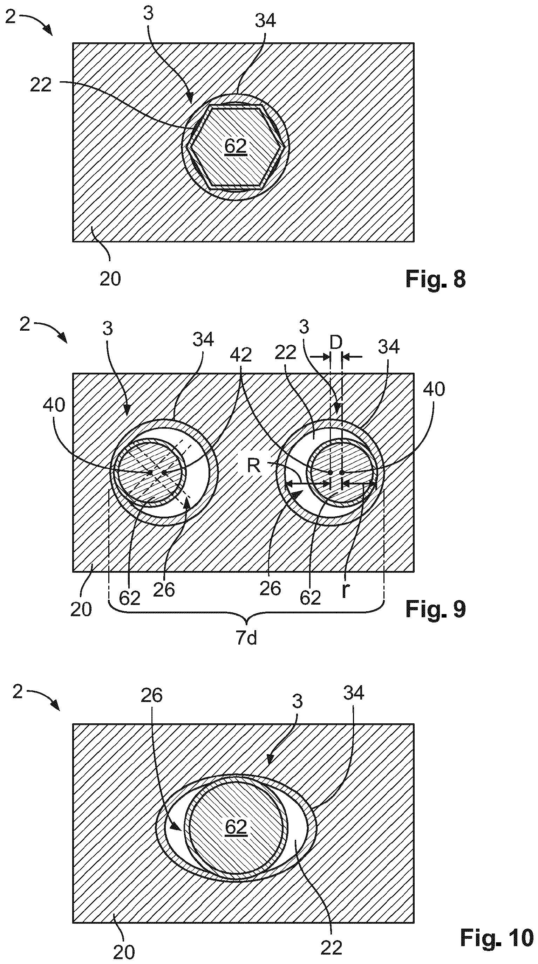

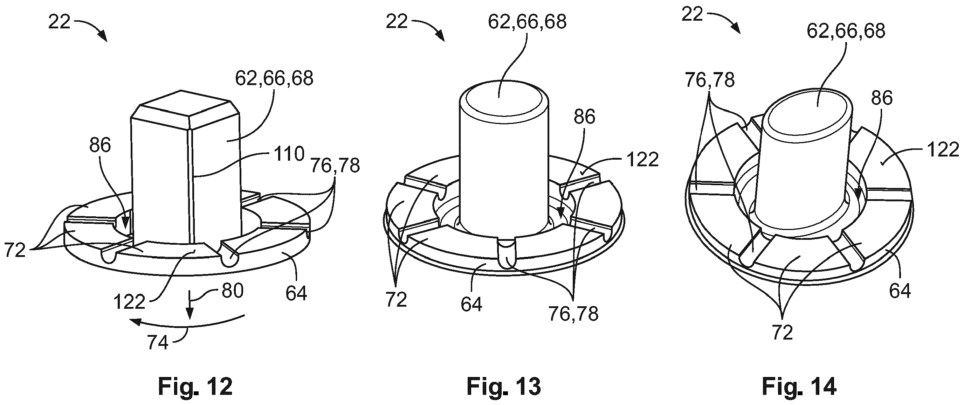

The at least one tenon 62 may be a pillar-shaped, pin-shaped, prism-shaped, pole-shaped and/or post-shaped finger 66 or protrusion 68. As such, the at least one tenon 62 may protrude from the top side 60 of the solid electrical conductor 22 along an axial direction 114. Further, the at least one tenon 62 may have a non-circular or circular cross section. For example, the at least one tenon 62 may have a square (see Fig. 4), rectangular (see Fig. 5), triangular (see Fig. 6), elliptical (see Fig. 7), polygonal (see Fig. 8) or circular (see Figs. 9 and 10) cross-section. In particular, an outer contour of the at least one tenon 62 may be cuboidal (see Fig. 12), cylindrical (see Fig. 13) or cylindroidal (see Fig. 14). Alternatively, the non-circular cross section of the tenon may have the shape of an oval, clover, cross or any other non-circular regular or irregular geometric form.

As can be seen in the respective top views of Fig. 4 to 10, in any given cross section of the tenon 62 that is perpendicular to the axial direction 114 of the tenon 62, the tenon 62 only 100 engages the lining 34 frictionally and electrically in sections. In other sections 102 of that same cross section, the lining 34 and the tenon 62 may be spaced apart and distanced from each other.

The at least one elevation 64 may extend continuously around the at least one tenon 62. For example, the at least one elevation 64 may be a ring-shaped bulge 70 on the top side 60 of the solid electrical conductor 22 encircling the at least one tenon 62 (see Fig. 2). As such, the at least one elevation 64 may form a substantially flat contact surface 122 for the at least one electrically conductive trace 44.

Alternatively, the at least one elevation 64 may extend discontinuously around the at least one tenon 62. For example, the at least one elevation 64 may be distributed around the at least one tenon 62 in the form of multiple ring segments 72 (see Figs. 12 to 14). The ring segments 72 are preferably distributed in a circular arrangement and evenly spaced apart from each other in a circumferential direction 74 with respect to the at least one tenon 62. Moreover, the ring segments 72 may be mutually coplanar and jointly form the contact surface 122. Between individual ring segments 72, slits 76 or notches 78 extend through the at least one elevation 64 along a radial direction 80 with respect to the at least one tenon 62.

Instead of the ring segments 72, convex knobs (not shown) with a dome shape, spike shape, pyramid shape, cylinder shape, star shape or any other convexly protruding shape may be distributed around the at least one tenon 62.

As can be seen in Fig. 2, the solid electrical conductor 22 may comprise at least one indent 82 on a bottom side 84 of the solid electrical conductor 22 facing away from the printed circuit board 20. More specifically, the at least one indent 82 is located opposite of the at least one tenon 62 and of the at least one elevation 64 with respect to the solid electrical conductor 22. This is a result of material displacement during the monolithic formation of the at least one tenon 62 and the at least one elevation 64 from the material of the solid electrical conductor 22.

Optionally, a groove 86 is formed on the solid electrical conductor 22 between the at least one tenon 62 and the at least one elevation 64 (see Fig. 12). Said groove 86 may be circular and/or annular and may extend around the at least one tenon 62 in the circumferential direction 74 with respect to the at least one tenon 62. In the radial direction 80 with respect to the at least one tenon 62, the groove 86 may separate the at least one tenon 62 and the at least one elevation 64 from each other.

In the shown embodiment of Fig. 1, the solid electrical conductor 22 may be a shunt resistor 88 with at least one resistive element 90 and at least one connection terminal 14 adjacent to the at least one resistive element 90. Preferably, the shunt resistor 88 comprises two connection terminals 14 with the resistive element 90 located in between. The at least one tenon 62 and the at least one elevation 64 may be monolithically formed from the material of the resistive element 90 or the connection terminals 14.

The connection terminals 14 may be made of the same materials as already mentioned for the solid electrical conductor 22. The resistive element 90 may be comprised of or consist of resistance alloys, which are conventionally known under names such as Manganin, Constantan, Isaohm or any other conductive material with a low thermal variation of its resistivity.

The shunt resistor 88 can be arranged in a circuit (not shown) in parallel with the voltmeter 92 in order to be used in the active shunt 6 already mentioned above. To achieve the parallel arrangement, the shunt resistor 88 may comprise a pair 94 of tenons 62 and a pair 96 of elevations 64. Preferably, one tenon 62 of the pair 94 and one elevation 64 of the pair 96 are positioned on each of two opposite sides of the resistive element 90. The voltmeter 92 is connected through the printed circuit board 20 with the tenons 62 and elevations 64 such that the resistive element 90 is parallel with the voltmeter 92.

In particular, each tenon 62 extends into one through-hole 26 of the printed circuit board 20, which comprises the necessary number of through-holes 26. Here, the through-holes 26 function as mortises and create the joints 3 with the corresponding tenons 62. Simultaneously, the electrically conductive linings 34 of the through-holes 26 enter into electrical contact with the corresponding tenons 62. If present, each elevation 64 is in electrical contact with one electrically conductive trace 44 of the printed circuit board 20, which comprises the necessary number of traces 44.

As shown in Figs. 2 to 4, the at least one tenon 62 may be engaged in a press-fit connection 106 with the printed circuit board 20 at the at least one through-hole 26. Optionally, the press-fit connection 106 is obtained by a so-called massive press fit. For this purpose, the at least one tenon 62 may have a slightly over-sized non-circular cross section and the at least one through-hole 26 may have a slightly under-sized circular cross section. This deliberate mismatch between the shapes and sizes of the cross sections can be best seen in Figs. 4 to 8. It is also conceivable that the at least one through-hole 26 has a non-circular cross section, while the at least one tenon 62 has a circular cross section (see Fig. 10).

With this mismatch in place, the at least one tenon 62 is forced into the at least one through-hole 26, as is depicted with arrows 108 in Fig. 2. Preferably, the at least one tenon 62 comprises at least one edge 110 that incises into the electrically conductive lining 34 of the at least one through-hole 26. In the course of this massive press fit, the electrically conductive lining 34 of the at least one through-hole 26 is at least in sections cold-welded with the at least one tenon 62.

According to another possible embodiment shown in Fig. 9, the at least one tenon may be arranged eccentrically with respect to the at least one through-hole and may one-sidedly engage with the electrically conductive lining 34 of the at least one through-hole 26. In particular, a distance D by which a middle axis 40 of the at least one tenon 62 is shifted from a middle axis 42 of the at least one through-hole 26 may be equal to or larger than the difference between the inner radius R of the at least one through-hole 26 and the outer radius r of the at least one tenon 62 (D ≥ *R* - r).

In this case, the circularity of the cross section of the at least one tenon 62 and the at least one through-hole 26 is irrelevant. However, it has to be ensured that the printed circuit board 20 cannot "shift back" relative to the solid electrical conductor 22. For example, at least one pair 7d of tenons 62 and through-holes 26 are provided, wherein the middle axes 40 of the tenons 62 are shifted in mutually opposite directions from the middle axes 42 of the through-holes 26 (see Fig. 9). Alternatively, if only one tenon and one through-hole are present, the aforementioned housing 8 may guarantee that the printed circuit board and the solid electrical conductor are fixated in their relative position, such that the at least one tenon is arranged eccentrically with respect to the at least one through-hole.

As suggested above, two or more tenons 62 may be formed on the solid electrical conductor 22, wherein each tenon 62 may be surrounded by an elevation 64 formed on the solid electrical conductor 22. Accordingly, the printed circuit board 20 may comprise two or more through-holes 26 optionally surrounded by electrically conductive traces 44 at respective locations corresponding with locations of the tenons 62 and elevations 64.

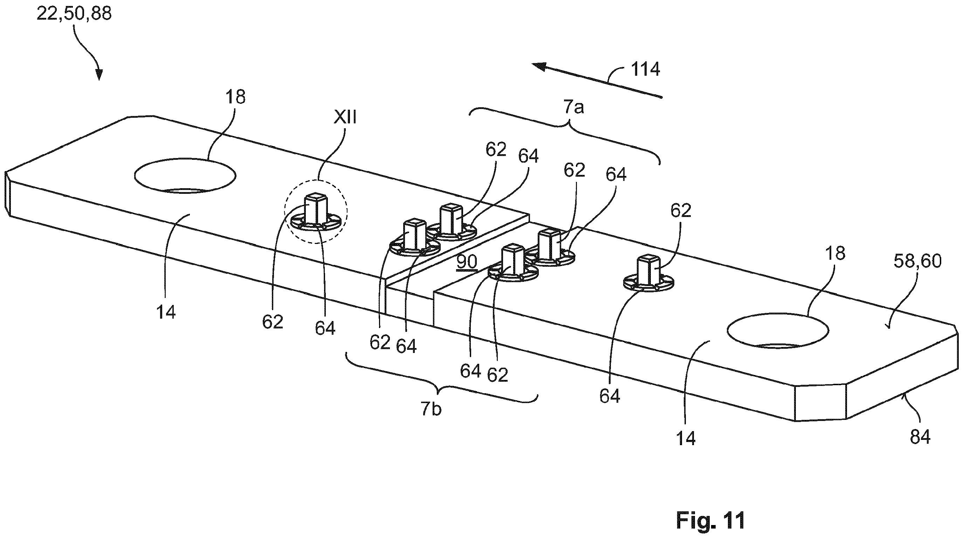

From Fig. 11 it can be seen that the two or more tenons 62 may be mutually parallel. The two or more through-holes 26 likewise may extend parallel to each other. The elevations 64 may be mutually coplanar, just like the electrically conductive traces 44 are mutually coplanar.

Optionally, at least two pairs 7a, 7b of tenons 62 and elevations 64 may be formed on the solid electrical conductor 22. Accordingly, at least two pairs of through-holes and conductive traces may be provided on the printed circuit board. In particular, the tenons 62 and elevations 64 of one pair 7a may have the same distance to each other as the tenons 62 and elevations 64 of the other pair 7b. Likewise, the through-holes and conductive traces of one pair may have the same distance to each other as the through-holes and conductive traces of the other pair. The tenons and elevations as well as the through-holes and conductive traces of each pair may be aligned along an axial direction 114 of the solid electrical conductor 22.

To directly implement a means for temperature compensation, the electrical assembly 2 may comprise a temperature sensor 116 arranged on the above-mentioned bottom side 32 of the printed circuit board 20 facing the solid electrical conductor 22. The temperature sensor 116 may be in thermal contact with the solid electrical conductor 22 directly and/or via a thermal paste 118 (see Fig. 3). The measured temperatures of the temperature sensor 116 may be read by the electrical measurement device 1 for the purpose of the temperature compensation.

Since, according to the present invention, no separate connection element is arranged between the printed circuit board 20 and the solid electrical conductor 22, the printed circuit board 20 and the solid electrical conductor 22 are relatively close to each other. This allows for the use of surface mount devices (SMD) for the temperature sensor 116. In particular, one or more negative temperature coefficient (NTC) thermistors 120 may be surface-mounted to the bottom side 32 of the printed circuit board 20 facing the solid electrical conductor 22.

The electrical sensor 4 of the electrical measurement device 1 is connected to the electrically conductive lining 34 of the at least one through-hole 26 of the printed circuit board 20. This is shown in Fig. 1. For example, the electrically conductive lining 34 may be connected with e.g., a sensor probe (not shown), a sensor wire (not shown) and/or an internal printed circuit board (not shown) of the electrical sensor 4.

Lastly, a method for the manufacturing of the electrical assembly 2 is explained:
First, a substantially flat solid electrical conductor (not shown in this state) and a printed circuit board 20 with at least one through-hole 26 having an electrically conductive lining 34 within the at least one through-hole 26 are provided.

The solid electrical conductor 22 is coined to monolithically form, from the material of the solid electrical conductor, at least one tenon 62 (see Fig. 2). This coining procedure may involve stamping, pressing, punching and/or embossing the solid electrical conductor 22. Moreover, a staged tool (not shown) and/or a progressive tool (not shown) may be used for this coining procedure.

Thereafter, the at least one tenon 62 is inserted into the at least one through-hole. This insertion procedure involves pressing in or press-fitting the at least one tenon 62 into the at least one through-hole 26. Thereby, the at least one tenon 62 is brought into electrical contact with the electrically conductive lining 34 of the at least one through-hole 26 (see Fig. 3).

Any references to standards made in the present disclosure are to be understood as pointing to the latest version of the respective standard at the application date of the present disclosure.

### REFERENCE SIGNS

- 1: electrical measurement device
- 2: electrical assembly
- 3: joint
- 4: electrical sensor
- 6: active shunt
- 7a, 7b, 7d: pair
- 8: housing
- 9a, 9b: housing half
- 12: access opening
- 14: connection terminals
- 16: card-edge connectors
- 18: screw hole
- 20: printed circuit board
- 22: solid electrical conductor
- 24: substrate
- 26: through-hole
- 28: via
- 30: top side
- 32: bottom side
- 34: lining
- 36: metallic plating
- 38: metallic coating
- 40: middle axis
- 42: middle axis
- 44: conductive trace
- 46: opening
- 48: busbar
- 50: shunt
- 52: coating
- 54: plating
- 56: brazing
- 58: flat side
- 60: top side
- 62: tenon
- 64: elevation
- 66: finger
- 68: protrusion
- 70: ring-shaped bulge
- 72: ring segment
- 74: circumferential direction
- 76: slit
- 78: notch
- 80: radial direction
- 82: indent
- 84: bottom side
- 86: groove
- 88: shunt resistor
- 90: resistive element
- 92: voltmeter
- 94: pair
- 96: pair
- 100: section
- 102: section
- 106: press-fit connection
- 108: arrow
- 110: edge
- 114: axial direction
- 116: temperature sensor
- 118: thermal paste
- 120: thermistor
- 122: contact surface
- 124: signal conditioning device
- 126: sleeve

## Claims

1. Joint (3) for attaching a printed circuit board (20) to a solid electrical conductor (22), wherein the joint (3) comprises:
- an electrically conductive lining (34), which lines an inner surface of a through-hole (26) in the printed circuit board (20), and
- a tenon (62) pressed in into the through-hole (26) being in frictional as well as in electrical contact with the electrically conductive lining (34),
wherein the tenon (62) is monolithically formed from material of the solid electrical conductor (22).

2. Joint (3) according to claim 1, wherein the electrically conductive lining (34) and the tenon (62) are sectionally cold welded to each other.

3. Joint (3) according to claim 1 or2, wherein the tenon (62) comprises at least one edge (110) incising into the electrically conductive lining (34).

4. Joint (3) according to any one of claims 1 to 3, wherein at least one of the tenon (62) and the electrically conductive lining (34) has a non-circular cross section.

5. Joint (3) according to any one of claims 1 to 4, wherein the tenon (62) is arranged eccentrically with respect to the electrically conductive lining (34).

6. Electrical assembly (2) for an electrical measurement device (1), the electrical assembly (2) comprising
- at least one joint (3) according to any one of claims 1 to 5,
- a solid electrical conductor (22) with the tenon (62) of the at least one joint (3), and
- a printed circuit board (20) with at least one through-hole (26) lined by the electrically conductive lining (34) of the at least one joint (3),
wherein the tenon (62) at least sectionally extends into the at least one through-hole (62).

7. Electrical assembly (2) according to claim 6, wherein, on a bottom side (84) of the solid electrical conductor (22) facing away from the printed circuit board (20), the solid electrical conductor (22) comprises at least one indent (82), and wherein the at least one indent (82) is located opposite of the at least one joint (3) with respect to the solid electrical conductor (22).

8. Electrical assembly (2) according to any one of claims 6 to 7, wherein the electrically conductive lining (34) is formed by at least one of a plating (36), a coating (38) and an insert sleeve.

9. Electrical assembly (2) according to claim 8, wherein an inner cross section of the insert sleeve has the shape of a square, rectangle, triangle, polygon, oval, ellipse, clover, cross or any other non-circular regular or irregular geometric form.

10. Electrical assembly (2) according to any one of claims 6 to 8, wherein the printed circuit board (20) comprises a substrate (24) made of glass-reinforced epoxy laminate material.

11. Electrical assembly (2) according to any one of claims 6 to 10, wherein the electrical assembly (2) comprises a temperature sensor (116) arranged on a bottom side (32) of the printed circuit board (20) facing the solid electrical conductor (22).

12. Electrical assembly (2) according to any one of claims 6 to 11, wherein the solid electrical conductor (22) is a shunt resistor (88) with at least one resistive element (90) and at least one connection terminal (14) arranged adjacent to the at least one resistive element (90).

13. Electrical measurement device (1) comprising an electrical assembly (2) according to any one of claims 6 to 12 and an electrical sensor (4), wherein the electrical sensor (4) is connected to the electrically conductive lining (34) of the at least one joint (3) of the electrical assembly (2).

14. Method for the manufacturing of an electrical assembly (2) comprising the steps of:
- providing a substantially flat solid electrical conductor and a printed circuit board (20) with at least one through-hole (26),
- lining the at least one through-hole (26) with an electrically conductive material,
- coining the solid electrical conductor to monolithically form, from the material of the solid electrical conductor, at least one tenon (62),
- pressing in the at least one tenon (62) into the at least one through-hole (26) to establish a frictional as well as electrical connection between the at least one tenon (62) and the electrically conductive material.

15. Solid electrical conductor (22) comprising at least one tenon (62), wherein, the at least one tenon (62) is obtained by plastically deforming the material of the solid electrical conductor (22).
